# EUROPÄISCHE PATENTSCHRIFT

(11) **EP 2 879 472 B1**
(45) Veröffentlichungstag und Bekanntmachung des Hinweises auf die Patenterteilung: **17.01.2018**
(21) Anmeldenummer: 14003597.3
(22) Anmeldetag: 22.10.2014
(51) Int. Cl.: H05K 5/00, B60T 8/36

(54) **Gehäuse für ein Steuergerät**
Housing for a control device
Boîtier pour un appareil de commande

(30) Priorität: 29.11.2013 DE 102013020255
(43) Veröffentlichungstag der Anmeldung: 03.06.2015
(73) Patentinhaber: WABCO GmbH, 30453 Hannover (DE)
(72) Erfinder: Bolik, Thomas, 30559 Hannover (DE); Kortlang, Tobias, 30989 Gehrden (DE); Wustrack, Tobias, 30455 Hannover (DE)

(56) Entgegenhaltungen:
- CH-A5- 659 164
- DE-A1- 19 545 011
- DE-B4- 19 528 252
- US-A- 4 126 224
- US-A- 5 497 036
- US-A- 5 762 224

## Beschreibung

Die Erfindung betrifft ein Gehäuse für ein Steuergerät, aufweisend eine Gehäusebasis, auf der über Kabel mit externen Aggregaten verbindbare Steuerungskomponenten montiert sind, eine haubenartige Abdeckung mit einer oberen Deckwand, einer Rückwand, zwei Seitenwänden und einer Vorderwand, an deren Unterkante Kabeldurchführungen bildende Ausnehmungen ausgebildet sind, und mit an der Gehäusebasis einerseits und der Abdeckung andererseits angeordneten Rastmitteln, die beim Aufschieben der Abdeckung auf die Gehäusebasis ineinander greifen.

Elektrische oder elektronische Steuergeräte enthalten in der Regel empfindliche elektrische, mechanische oder Druckmittel-Steuerungskomponenten, die vor Umgebungseinflüssen geschützt werden müssen. Insbesondere in Nutzfahrzeugen und Personenwagen sind Steuergeräte häufig an Stellen angeordnet, wo sie einer Verschmutzung, Feuchtigkeit und mechanischen Belastungen ausgesetzt sind. Die Gehäuse für derartige Steuergeräte müssen deshalb so beschaffen sein, dass sie einen ausreichenden Schutz gegen derartige Umgebungseinflüsse gewährleisten. Wegen des im Allgemeinen begrenzten Einbauraumes ist es zudem wichtig, dass zu Wartungs- und Reparaturzwecken die Steuerungskomponenten möglichst leicht zugänglich gemacht werden, so dass ein Deckel des Steuergeräts leicht und mit geringem Lösehub abnehmbar ist.

Bei vielen derzeit eingesetzten Steuergeräten sind die oben genannten Anforderungen nur unvollkommen erfüllt, denn sie bieten im eingebauten Zustand nicht selten nur einen unzureichenden Schutz gegen Sprüh- und Spritzwasser, gegen Staub und Schmutz sowie gegen mechanische Belastungen, und für deren Montage beziehungsweise Demontage insbesondere der des Deckels beziehungsweise der Abdeckung des Steuergeräts ist ein großer Freiraum erforderlich.

Aus der DE 195 28 252 B4 ist bereits ein Aggregat mit einem Gehäuse der im Oberbegriff des Anspruchs 1 genannten Art bekannt, bei welchem eine haubenartige Abdeckung zur Montage auf eine aus einem Gehäuseblock und einem Gehäusedeckel bestehende Gehäusebasis aufgeschoben wird, wobei beim Aufschieben der Abdeckung an der Gehäusebasis einerseits und der Abdeckung andererseits angeordnete Rastmittel ineinander greifen. Um die Abdeckung nach der Montage gegen ein Verschieben in Demontagerichtung zu sichern, schnappt ein abgekanteter Randstreifen elastisch hinter eine Gehäusedeckelkante. Um die Abdeckung zu demontieren, muss der abgekantete Randstreifen elastisch aus seiner Sicherungsposition bewegt und sodann die Abdeckung in die Demontagerichtung verschoben werden. Die Abdeckung ist deshalb verhältnismäßig leicht und flexibel ausgeführt, so dass sie zumindest keinen ausreichenden Schutz gegen mechanische Belastung, insbesondere zum Beispiel keine Trittfestigkeit bietet.

Vor diesem Hintergrund liegt der Erfindung die Aufgabe zugrunde, ein Gehäuse für ein Steuergerät der im Oberbegriff der Ansprüche 1 und 5 genannten Art zu schaffen, welches im eingebauten Zustand einen ausreichenden Schutz gegen Sprüh- und Spritzwasser, Staub und Schmutz sowie mechanische Belastungen bietet, wobei die Abdeckung mit einem möglichst geringen Lösehub demontierbar sein soll.

Die Lösung der oben genannten Aufgabe ergibt sich aus den Merkmalen des Anspruchs 1 sowie des Anspruchs 5, während vorteilhafte Ausgestaltungen und Weiterbildungen der Erfindung den jeweiligen Unteransprüchen entnehmbar sind.

Die Erfindung betrifft demnach Steuergerät, aufweisend eine Gehäusebasis, auf der über Kabel mit externen Aggregaten verbindbare Steuerungskomponenten montiert sind, eine haubenartige Abdeckung mit einer oberen Deckwand, einer Rückwand, zwei Seitenwänden und einer Vorderwand, an deren Unterkante Kabeldurchführungen bildende Ausnehmungen ausgebildet sind, und mit an der Gehäusebasis einerseits und der Abdeckung andererseits angeordneten Rastmitteln, die beim Aufschieben der Abdeckung auf die Gehäusebasis ineinander greifen.

Es sei an dieser Stelle bemerkt, dass die Begriffe "oben", "unten", "hinten" und "vorne" auf eine normale Lage des Steuergerätes bezogen sind, bei der die Abdeckung in einer horizontalen Ebene von hinten nach vorne auf die Gehäusebasis aufgeschoben wird.

Zur Lösung der oben genannten Aufgabe ist gemäß einer ersten Ausführungsform vorgesehen, dass an der Unterkante der Rückwand der Abdeckung über deren gesamte Breite ein schräg nach unten und vorne gerichteter Laschenfortsatz angeordnet ist, der beim Aufschieben der Abdeckung auf die Gehäusebasis von hinten nach vorne in eine zugeordnete, an der Gehäusebasis ausgebildete Rinne mit einem nach vorne keilförmig zugespitzten Querschnitt eingreift, und dass im vorderen Bereich der Abdeckung und der Gehäusebasis verrastbare sowie lösbare Rastmittel vorgesehen sind, welche die Abdeckung gegen ein Abheben sowie ein Verschieben nach hinten sichern.

Zur Montage der Abdeckung auf der Gehäusebasis wird die Abdeckung demnach so über die Gehäusebasis geschoben, dass der Laschenfortsatz der Abdeckung in die Rinne der Gehäusebasis eingreift, wobei die Abdeckung in ihrem hinteren Bereich aufgrund der beschriebenen Ausgestaltung der Rinne nach unten an die Gehäusebasis angedrückt wird.

Dass die hintere untere Kante der Abdeckung abgeschrägt ausgebildet ist, bietet den zusätzlichen Vorteil, dass sie eine Tropfkante für ablaufendes Spritzwasser bildet.

Der Laschenfortsatz der Abdeckung kann gemäß einer günstigen Ausgestaltung der Erfindung zu seiner Endkante hin wulstartig verdickt ausgebildet sein und bildet so mit der am Rinnenboden gelenkpfannenartig ausgerundeten Rinne eine Art Schwenkgelenk, welches ein Abheben nur des vorderen Bereiches der Abdeckung nach oben erlaubt.

Bei der Montage wird die Abdeckung mit leicht nach oben abgehobenem vorderen Ende nach vorne über die Gehäusebasis geschoben, bis der Laschenfortsatz in die Rinne eingreift. Sodann wird die Abdeckung nach unten geschwenkt, wobei an der Abdeckung angeordnete Rastmittel in Rastausnehmungen eingreifen, wie nachfolgend näher beschrieben wird.

Eine diesbezügliche Ausgestaltung der Erfindung sieht vor, dass die gegen ein Verschieben der Abdeckung nach hinten sichernden Rastmittel wenigstens einen an einer Seitenwand angeordneten, nach unten ragenden Vorsprung aufweisen, welcher im montierten Zustand, also bei abgesenktem vorderen Ende der Abdeckung, in eine zugeordnete Ausnehmung an der Gehäusebasis eingreift.

Um die Abdeckung gegen ein Abheben ihres vorderen Bereiches zu sichern, weisen die diesbezüglichen Rastmittel wenigstens eine an der Vorderwand der Abdeckung angeordnete Rastlasche auf, die im montierten Zustand der Abdeckung mit einer an der Gehäusebasis ausgebildeten Rastnase verrastbar ist, beziehungsweise umgekehrt, das heißt, die Rastlasche kann an der Gehäusebasis und die Rastnase an der Abdeckung angeordnet sein.

Eine zweite Ausführungsform der vorliegenden Erfindung betrifft das gleiche Gehäuse für ein Steuergerät, aufweisend eine Gehäusebasis, auf der über Kabel mit externen Aggregaten verbindbare Steuerungskomponenten montiert sind, eine haubenartige Abdeckung mit einer oberen Deckwand, einer Rückwand, zwei Seitenwänden und einer Vorderwand, an deren Unterkante Kabeldurchführungen bildende Ausnehmungen ausgebildet sind, und mit an der Gehäusebasis einerseits und der Abdeckung andererseits angeordneten Rastmitteln, die beim Aufschieben der Abdeckung auf die Gehäusebasis ineinander greifen. Zur Lösung der gleichen Aufgabe ist mit Abweichung zu der ersten Ausführungsform vorgesehen, dass an der Außenseite der Seitenwände jeweils mit Abstand hintereinander zwei Rastnocken ausgebildet sind, welche beim Aufschieben der Abdeckung auf die Gehäusebasis in zugeordnete, an Seitenstegen der Gehäusebasis ausgebildete, nach hinten offene und im Wesentlichen schräg nach unten und vorne geneigte Rastschlitze eingreifen, und dass im vorderen Bereich der Abdeckung und der Gehäusebasis verrastbare sowie lösbare Rastmittel vorgesehen sind, welche die Abdeckung gegen ein Verschieben nach hinten sichern.

Bei dieser zweiten Ausführungsform des Steuergerätgehäuses wird mit der Aufschiebebewegung die Abdeckung wegen der beschriebenen Ausgestaltung der Rastschlitze nach unten gegen die Gehäusebasis gedrückt, so dass die Unterkanten der Rückwand und der Seitenwände auf zugeordneten Flächen der Gehäusebasis abdichtend aufliegen. Die im vorderen Bereich der Abdeckung und der Gehäusebasis angeordneten Rastmittel werden verrastet und verhindern so ein Verschieben der Abdeckung nach hinten.

Die gegen ein Verschieben nach hinten sichernden Rastmittel umfassen gemäß einer weiteren Ausgestaltung der Erfindung wenigstens eine an einer Seitenwand der Abdeckung angeordnete Rastlasche, die im montierten Zustand der Abdeckung mit einer an der Gehäusebasis ausgebildeten Rastnase verrastbar ist, beziehungsweise umgekehrt, das heißt, die wenigstens eine Rastlasche und die wenigstens eine Rastnase können auch vertauscht angeordnet sein.

Gemäß einer bevorzugten Ausgestaltung der Erfindung erstreckt sich die Vorderwand der Abdeckung jeweils nach unten bis zur Höhe einer auf der Gehäusebasis stehenden Vorderwand, wobei an der Oberkante der Vorderwand der Gehäusebasis etwa teilkreisförmige Ausnehmungen ausgebildet sind, die sich mit teilkreisförmigen Ausnehmungen an der Unterkante der Vorderwand der Abdeckung zu im Wesentlichen kreisförmigen Kabeldurchführungsöffnungen ergänzen. Wie an sich bekannt ist, haben die Kabeldurchführungsöffnungen einen etwas geringeren Durchmesser als die durch diese hindurchführenden Kabel, so dass die Kabel bei der Montage der Abdeckung im Sinne einer Zugentlastung etwas eingeklemmt werden.

Die weiter vorne beschriebenen, an der Gehäusebasis ausgebildeten Rastnasen beziehungsweise Rastlaschen sind gemäß einer weiteren Ausgestaltung der Erfindung jeweils an der oben beschriebenen Vorderwand der Gehäusebasis ausgebildet oder angeordnet, wie anhand von Ausführungsbeispielen noch dargelegt wird.

Gemäß einer weiteren Ausgestaltung der Erfindung sind auf der Oberseite der Gehäusebasis jeweils entlang der Seitenwände der montierten Abdeckung sich erstreckende Rinnen zum Sammeln und Abführen von von der Abdeckung ablaufendem Spritzwasser ausgebildet.

Schließlich kann gemäß einer vorteilhaften Ausführungsform vorgesehen sein, dass an der Vorderwand der Abdeckung eine Führungsnase angeordnet ist, die beim Schließen der Abdeckung in eine zugeordnete, an der Vorderwand der Gehäusebasis ausgebildete Ausnehmung eingreift.

Die Erfindung wird nachfolgend anhand mehrerer Ausführungsbeispiele weiter erläutert. Dazu ist der Beschreibung eine Zeichnung beigefügt. In dieser zeigt
Fig. 1 in einer perspektivischen Ansicht ein elektrisches Steuergerät mit einer an eine Gehäusebasis angesetzten, jedoch noch nicht geschlossenen Abdeckung,
Fig. 2 eine Seitenansicht des elektrischen Steuergeräts gemäß Fig. 1 mit geschlossener Abdeckung sowie etwa in der Mitte teilweise geschnitten zur Darstellung einer Ablaufrinne,
Fig. 3 eine Seitenansicht des elektrischen Steuergeräts gemäß Fig. 1 mit geschlossener Abdeckung sowie an einer Seite geschnitten zur Darstellung von Befestigungsmittel,
Fig. 4 eine Ansicht ähnlich der Fig. 1, jedoch mit geschlossener Abdeckung,
Fig. 5 und Fig. 6 jeweils Einzelheiten aus der Fig. 4,
Fig. 7 schematisch eine Seitenansicht einer zweiten Ausführungsform eines Steuergeräts mit geschlossener Abdeckung, und
Fig. 8 eine perspektivische Ansicht des Steuergeräts gemäß Fig. 7.

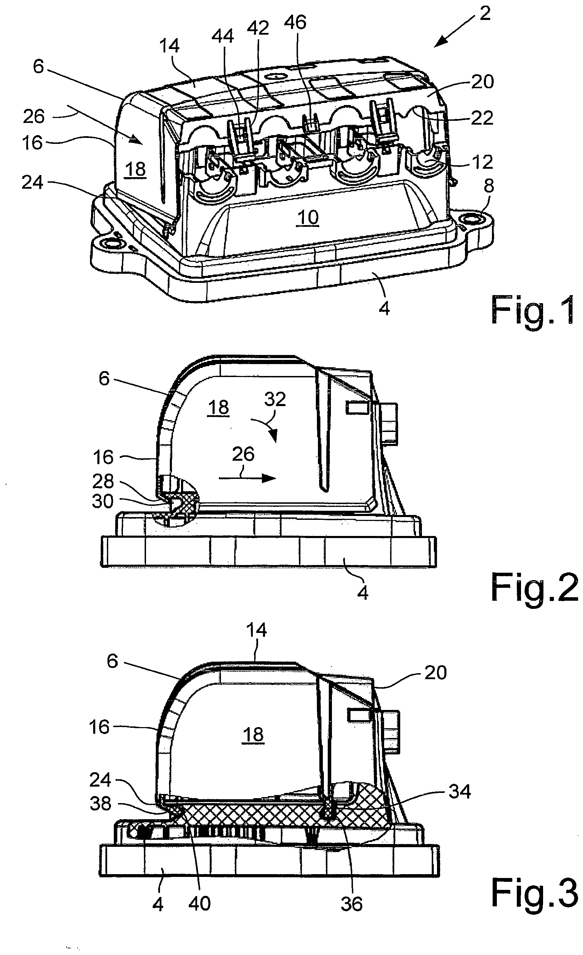

Das in Fig. 1 dargestellte Steuergerät 2 weist eine Gehäusebasis 4 auf, auf der hier nicht im einzelnen dargestellte Steuerungskomponenten und Steckerbuchsen montiert sind, sowie eine haubenartige Abdeckung 6, die auf die Gehäusebasis 4 aufgesetzt beziehungsweise von dieser abgenommen werden kann. Die Gehäusebasis 4 weist Befestigungsaugen 8 auf, die Befestigungsschrauben für eine Befestigung des Steuergerätes an einer zu steuernden Maschine, beispielsweise in einem Kraftfahrzeug, aufnehmen können. Im vorderen Bereich der Gehäusebasis 4 ist eine auf dieser senkrecht stehende Vorderwand 10 angeordnet, an deren Oberkante vier teilkreisförmige Ausnehmungen 12 zur Führung und Halterung von nicht dargestellten Kabeln dienen, die mit auf der Gehäusebasis angeordneten Steckerbuchsen verbindbar sind.

Die Abdeckung 6 besteht im Wesentlichen aus einer Deckwand 14, einer in Fig.1 1 nicht sichtbaren, weil dem Betrachter abgewandten Rückwand 16, zwei Seitenwänden 18, von denen in der perspektivischen Darstellung wiederum nur eine zu sehen ist, sowie einer die Vorderseite der Abdeckung 6 nur teilweise abschließenden Vorderwand 20. Diese Vorderwand 20 fluchtet bei montierter und geschlossener Stellung der Abdeckung 6 im Wesentlichen mit der Vorderwand 10 der Gehäusebasis 4. An der Unterkante der Vorderwand 20 sind ebenfalls teilkreisförmige Ausnehmungen 22 ausgebildet, die sich mit den Ausnehmungen 12 an der Vorderwand 10 der Gehäusebasis 4 zu im Wesentlichen kreisförmigen Kabeldurchführungsöffnungen ergänzen.

Um die Abdeckung 6 auf der Gehäusebasis 4 zu montieren, wird diese, wie in Fig. 1 dargestellt, in vorne leicht nach oben gekippter Lage mit ihrer Hinterkante 24 auf die Gehäusebasis 4 aufgesetzt, sodann in einem zweiten Schritt in Richtung des Pfeils 26 nach vorne verschoben und anschließend nach unten verschwenkt, wobei die Unterkanten der Seitenwände 18 sich abdichtend auf die Oberseite der Gehäusebasis 4 und die Unterkante der Vorderwand 20 der Abdeckung sich auf die Oberkante der Vorderwand 10 der Gehäusebasis auflegen.

Wie die Figuren 2 und 3 erkennen lassen, greift beim Vorschieben der Abdeckung 6 aus der in Fig. 1 gezeigten Stellung ein an der Unterkante der Rückwand 16 angeordneter Laschenfortsatz 28 in eine an der Gehäusebasis 4 ausgebildete Rinne 30 ein, die einen nach vorne im Wesentlichen keilförmig zugespitzten Querschnitt aufweist. Infolge der schrägen Ausbildung des Laschenfortsatzes 28 wird die Hinterkante der Abdeckung 6 beim Vorschieben in Richtung des Pfeils 26 nach unten an die Gehäusebasis 4 angedrückt. Nach dem Verschwenken der Abdeckung 6 nach unten in Richtung des Pfeils 32 wird diese in ihrer geschlossenen Stellung fixiert. Dazu sind im vorderen Bereich der Abdeckung 6 einerseits und der Gehäusebasis 4 andererseits verrastbare sowie lösbare Rastmittel vorgesehen, welche die Abdeckung gegen ein Abheben sowie ein Verschieben nach hinten sichern, wie nachfolgend beschrieben wird.

Wie insbesondere Fig. 3 zeigt, ist wenigstens an einer Seitenwand 18 der Abdeckung 6 ein nach unten ragender Vorsprung 34 ausgebildet, welcher im montierten, also nach unten geschwenkten Zustand der Abdeckung 6 in eine zugeordnete Ausnehmung 36 an der Gehäusebasis 4 eingreift. Auf diese Weise wird ein Verschieben der Abdeckung 6 nach hinten verhindert. Die Fig. 3 zeigt außerdem eine gegenüber Fig. 2 leicht abgewandelte Ausgestaltung eines Laschenfortsatzes 38, welcher zu seiner Endkante hin wulstartig verdickt ist und mit dem etwa gelenkpfannenartig ausgerundeten Boden der zugeordneten Rinne 40 eine Art Schwenkgelenk bildet.

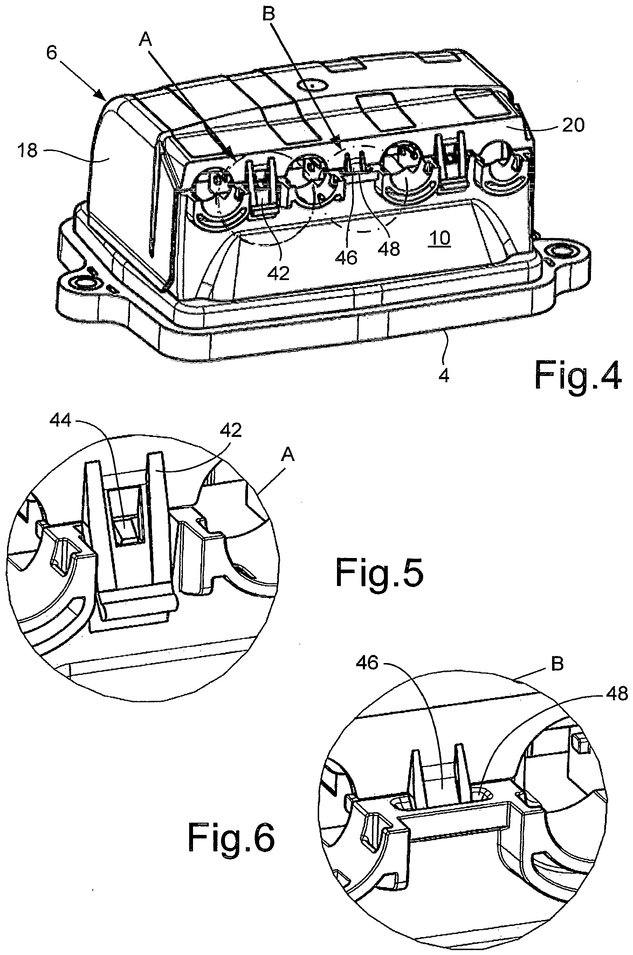

Um die Abdeckung 6 gegen ein Abheben aus der geschlossenen Stellung zu sichern, sind, wie in Fig. 4 dargestellt ist, an der Vorderwand 20 der Abdeckung 6 elastische Rastlaschen 42 angeordnet, die mit an der Vorderwand 10 der Gehäusebasis 4 ausgebildeten, jeweils zugeordneten Rastnasen 44 verrastbar sind. Fig. 5 zeigt diese Einzelheit im Ausschnitt A in vergrößerter Darstellung. Die Rastlaschen 42 können zum Entfernen der Abdeckung manuell leicht, also ohne Werkzeug gelöst werden.

Um die Abdeckung 6 beim Schließen zu führen und im geschlossenen Zustand zusätzlich zu fixieren, ist an der Vorderwand 20 der Abdeckung 6 eine mit ihrem freien Ende nach unten weisende Führungsnase 46 angeordnet, die beim Schließen der Abdeckung 6 in eine zugeordnete, an der Vorderwand 10 der Gehäusebasis 4 ausgebildete Ausnehmung 48 eingreift. Fig. 6 zeigt dieses Detail in einem Ausschnitt B in vergrößerter Darstellung.

Die von dem jeweiligen Laschenfortsatz 28, 38 gebildete hintere Unterkante der Abdeckung 6 bildet eine Abschrägung und dient damit als Tropfkante für ablaufendes Spritzwasser.

Es ist erkennbar, dass der für eine Montage oder Demontage jeweils erforderliche Lösehub und auch die Verschiebestrecke äußerst gering sind, wobei die Gehäusebasis 4 und die Abdeckung 6 vorzugsweise so ausgelegt sind, dass die Abdeckung 6 beim Verschieben innerhalb der Grundfläche der Gehäusebasis 4 bleibt.

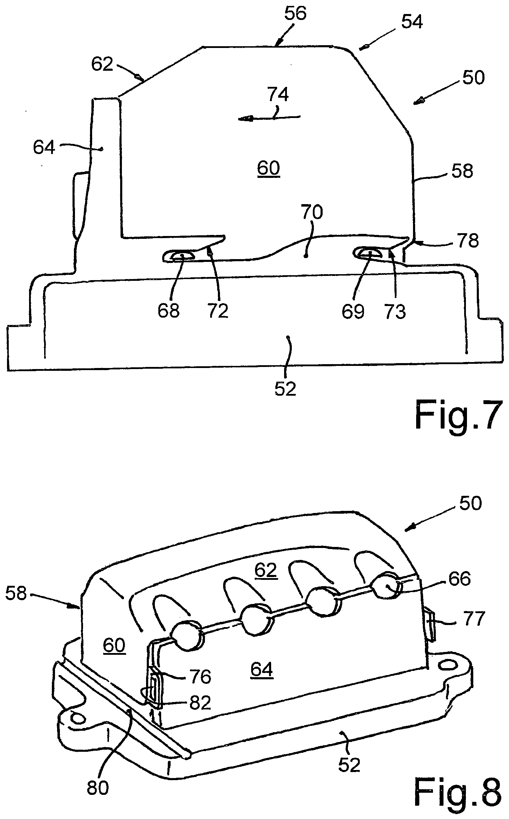

Die Figuren 7 und 8 zeigen ein Steuergerät 50 mit einer Gehäusebasis 52 und einer Abdeckung 54. Die Abdeckung 54 ist ähnlich aufgebaut wie die Abdeckung 6 in den Figuren 1 und 4, das heißt, sie hat eine Deckwand 56, eine Rückwand 58 und zwei Seitenwände 60 sowie eine im vorliegenden Fall schräge Vorderwand 62, die sich im geschlossenen Zustand der Abdeckung an eine Vorderwand 64 der Gehäusebasis 52 anlegt. Dabei bilden wiederum an der Unterkante der Vorderwand 62 der Abdeckung 54 einerseits und an der Oberkante der Vorderwand 64 der Gehäusebasis 52 andererseits ausgebildete Ausnehmungen jeweils kreisförmige Kabeldurchführungsöffnungen 66.

An der Außenseite der Seitenwände 60 sind jeweils mit Abstand hintereinander zwei Rastnocken 68, 69 ausgebildet, die beim Aufschieben der Abdeckung 54 in zugeordnete, an Seitenstegen 70 der Gehäusebasis 52 ausgebildete, nach hinten offene, im Wesentlichen schräg nach unten und vorne geneigte sowie sich verengende Rastschlitze 72, 73 eingreifen. Wegen der schrägen Ausgestaltung der Rastschlitze 72, 73 wird die Abdeckung 56 beim Vorschieben in Richtung des Pfeils 74 nach unten auf die Gehäusebasis 52 gedrückt.

Um eine Verschiebung der Abdeckung 56 nach hinten zu verhindern, sind an den Seitenwänden 60 der Abdeckung 56 elastische Rastlaschen 76, 77 angeordnet, welche mit an den Seitenkanten der Vorderwand 62 der Gehäusebasis 52 ausgebildeten, in der Fig. 8 nicht im Einzelnen dargestellten Rastnasen 82 verrastet werden können.

Die hintere Unterkante 78 der Abdeckung 54 ist wiederum abgeschrägt und bildet eine Tropfkante für Spritzwasser. Auf der Oberseite der Gehäusebasis 52 entlang der Seitenwände 60 sind Rinnen 80 zum Sammeln und Abführen von Spritzwasser ausgebildet.

### Bezugszeichenliste (Bestandteil der Beschreibung)

- 2: Steuergerät
- 4: Gehäusebasis
- 6: Abdeckung
- 8: Befestigungsauge
- 10: Vorderwand der Gehäusebasis 4
- 12: Ausnehmung an der Vorderwand 10
- 14: Deckwand der Abdeckung 6
- 16: Rückwand der Abdeckung 6
- 18: Seitenwand der Abdeckung 6
- 20: Vorderwand der Abdeckung 6
- 22: Ausnehmung an der Vorderwand 20
- 24: Hinterkante der Abdeckung 6
- 26: Pfeil, Verschieberichtung
- 28: Laschenfortsatz an der Abdeckung 6
- 30: Rinne
- 32: Pfeil, Verschieberichtung
- 34: Vorsprung an der Abdeckung 6
- 36: Ausnehmung in der Gehäusebasis 4
- 38: Laschenfortsatz an der Abdeckung 6
- 40: Rinne
- 42: Rastlasche
- 44: Rastnasen
- 46: Führungsnase
- 48: Ausnehmung
- 50: Steuergerät
- 52: Gehäusebasis
- 54: Abdeckung
- 56: Deckwand der Abdeckung 54
- 58: Rückwand der Abdeckung 54
- 60: Seitenwände der Abdeckung 54
- 62: Vorderwand der Abdeckung 54
- 64: Vorderwand der Gehäusebasis 52
- 66: Kabeldurchführungsöffnung
- 68: Erster Rastnocken
- 69: Zweiter Rastnocken
- 70: Seitensteg
- 72: Erster Rastschlitz
- 73: Zweiter Rastschlitz
- 74: Pfeil, Verschieberichtung
- 76: Erste Rastlasche
- 77: Zweite Rastlasche
- 78: Unterkante der Abdeckung 54
- 80: Rinne
- 82: Rastnase

## Patentansprüche

1. Gehäuse für ein Steuergerät (2), aufweisend eine Gehäusebasis (4), auf der über Kabel mit externen Aggregaten verbindbare Steuerungskomponenten montiert sind, eine haubenartige Abdeckung (6) mit einer oberen Deckwand (14), einer Rückwand (16), zwei Seitenwänden (18) und einer Vorderwand (20), an deren Unterkante Kabeldurchführungen (66) bildende Ausnehmungen (22) ausgebildet sind, und mit an der Gehäusebasis (4) einerseits und der Abdeckung (6) andererseits angeordneten Rastmitteln, die beim Aufschieben der Abdeckung (6) auf die Gehäusebasis (4) ineinander greifen, wobei im vorderen Bereich der Abdeckung (6) und der Gehäusebasis (4) verrastbare sowie lösbare Rastmittel vorgesehen sind, welche die Abdeckung (6) gegen ein Abheben sowie ein Verschieben nach hinten sichern, **dadurch gekennzeichnet, dass** an der Unterkante der Rückwand (16) der Abdeckung (6) über deren gesamte Breite ein schräg nach unten und vorne gerichteter Laschenfortsatz (28) angeordnet ist, der beim Aufschieben der Abdeckung (6) auf die Gehäusebasis (4) von hinten nach vorne in eine zugeordnete, an der Gehäusebasis (4) ausgebildete Rinne (30) mit einem nach vorne keilförmig zugespitzten Querschnitt eingreift.

2. Gehäuse nach Anspruch 1, **dadurch gekennzeichnet, dass** der Laschenfortsatz (38) der Abdeckung (6) zu seiner Endkante hin wulstartig verdickt und die Rinne (40) am Rinnenboden gelenkpfannenartig ausgerundet ist.

3. Gehäuse nach Anspruch 1 oder 2, **dadurch gekennzeichnet, dass** die gegen ein Verschieben der Abdeckung (6) nach hinten sichernden Rastmittel wenigstens einen an einer Seitenwand (18) angeordneten, nach unten ragenden Vorsprung (34) aufweisen, welcher im montierten Zustand der Abdeckung (6) in eine zugeordnete Ausnehmung (36) an der Gehäusebasis (4) eingreift.

4. Gehäuse nach einem der Ansprüche 1 bis 3, **dadurch gekennzeichnet, dass** die gegen ein Abheben der Abdeckung (6) sichernden Rastmittel wenigstens eine an der Vorderwand (10) der Abdeckung (6) angeordnete Rastlasche (42) aufweisen, die im montierten Zustand der Abdeckung (6) mit einer an der Gehäusebasis (4) ausgebildeten Rastnase (44) verrastbar sind, beziehungsweise umgekehrt.

5. Gehäuse für ein Steuergerät (2), aufweisend eine Gehäusebasis (4), auf der über Kabel mit externen Aggregaten verbindbare Steuerungskomponenten montiert sind, eine haubenartige Abdeckung (6) mit einer oberen Deckwand (14), einer Rückwand (16), zwei Seitenwänden (18) und einer Vorderwand (20), an deren Unterkante Kabeldurchführungen (66) bildende Ausnehmungen (22) ausgebildet sind, und mit an der Gehäusebasis (4) einerseits und der Abdeckung (6) andererseits angeordneten Rastmitteln, die beim Aufschieben der Abdeckung (6) auf die Gehäusebasis (4) ineinander greifen, wobei im vorderen Bereich der Abdeckung (6) und der Gehäusebasis (4) verrastbare sowie lösbare Rastmittel vorgesehen sind, welche die Abdeckung (6) gegen ein Abheben sowie ein Verschieben nach hinten sichern, **dadurch gekennzeichnet, dass** an der Außenseite der Seitenwände (60) jeweils mit Abstand hintereinander zwei Rastnocken (68, 69) ausgebildet sind, welche beim Aufschieben der Abdeckung (54) auf die Gehäusebasis (52) in zugeordnete, an Seitenstegen (70) der Gehäusebasis (52) ausgebildete, nach hinten offene und im Wesentlichen schräg nach unten und vorne geneigte Rastschlitze (72, 73) eingreifen.

6. Gehäuse nach Anspruch 5, **dadurch gekennzeichnet, dass** die gegen ein Verschieben nach hinten sichernden Rastmittel wenigstens eine an einer Seitenwand (60) der Abdeckung (54) angeordnete Rastlasche (76, 77) umfassen, die im montierten Zustand der Abdeckung (54) mit einer an der Gehäusebasis (52) ausgebildeten Rastnase verrastbar ist, beziehungsweise umgekehrt.

7. Gehäuse nach einem der Ansprüche 1 bis 6, **dadurch gekennzeichnet, dass** die Vorderwand (20) der Abdeckung (6) sich nach unten bis zur Höhe einer auf der Gehäusebasis (4) stehenden Vorderwand (10) erstreckt, und dass an der Oberkante der Vorderwand (10) der Gehäusebasis (4) etwa teilkreisförmige Ausnehmungen (12) ausgebildet sind, die sich mit etwa teilkreisförmigen Ausnehmungen (22) an der Unterkante der Vorderwand (20) der Abdeckung (6) zu im Wesentlichen kreisförmigen Kabeldurchführungsöffnungen ergänzen.

8. Gehäuse nach Anspruch 4 oder 5 in Verbindung mit Anspruch 7, **dadurch gekennzeichnet, dass** die an der Gehäusebasis (4) ausgebildete Rastnase (44) beziehungsweise Rastlasche (42) jeweils an der Vorderwand (10) der Gehäusebasis (4) ausgebildet oder angeordnet ist.

9. Gehäuse nach einem der Ansprüche 1 bis 8, **dadurch gekennzeichnet, dass** auf der Oberseite der Gehäusebasis (52) jeweils entlang der Seitenwände (60) der montierten Abdeckung (54) sich erstreckende Rinnen (80) zum Sammeln und Abführen von von der Abdeckung ablaufendem Spritzwasser ausgebildet sind.

10. Gehäuse nach einem der Ansprüche 1 bis 9, **dadurch gekennzeichnet, dass** an der Vorderwand (20) der Abdeckung (6) eine Führungsnase (46) angeordnet ist, die beim Schließen der Abdeckung (6) in eine zugeordnete, an der Vorderwand (10) der Gehäusebasis (4) ausgebildete Ausnehmung (48) eingreift.

## Claims

1. Housing for a control device (2), having a housing base (4) on which control components, which can be connected to external assemblies by means of cables, are mounted, a hood-like cover (6) with an upper top wall (14), a rear wall (16), two side walls (18) and a front wall (20), recesses (22) which form cable bushings (66) being formed at the lower edge of the said front wall, and having latching means which are arranged on the housing base (4) on the one hand and on the cover (6) on the other hand and interengage when the cover (6) is pushed onto the housing base (4), wherein the latchable and releasable latching means are provided in the front region of the cover (6) and of the housing base (4) and prevent the cover (6) from lifting off and moving to the rear, **characterized in that** a tab extension (28) which is directed obliquely downwards and forwards is arranged at the lower edge of the rear wall (16) of the cover (6) over the entire width thereof and, when the cover (6) is pushed onto the housing base (4), engages from the rear to the front into an associated channel (30) which is formed on the housing base (4) and has a cross section which is tapered in the manner of a wedge towards the front.

2. Housing according to Claim 1, **characterized in that** the tab extension (38) of the cover (6) is thickened in the manner of a bead in the direction of its end edge and the channel (40) is rounded in the manner of a socket at the channel base.

3. Housing according to Claim 1 or 2, **characterized in that** the latching means which prevent movement of the cover (6) to the rear have at least one downwardly protruding projection (34) which is arranged on a side wall (18) and, in the mounted state of the cover (6), engages into an associated recess (36) on the housing base (4).

4. Housing according to one of Claims 1 to 3, **characterized in that** the latching means which prevent the cover (6) from lifting off have at least one latching tab (42) which is arranged on the front wall (10) of the cover (6) and, in the mounted state of the cover (6), can latch with a latching lug (44) which is formed on the housing base (4), or vice versa.

5. Housing for a control device (2) having a housing base (4) on which control components, which can be connected to external assemblies by means of cables, are mounted, a hood-like cover (6) with an upper top wall (14), a rear wall (16), two side walls (18) and a front wall (20), recesses (22) which form cable bushings (66) being formed at the lower edge of the said front wall, and having latching means which are arranged on the housing base (4) on the one hand and on the cover (6) on the other hand and interengage when the cover (6) is pushed onto the housing base (4), wherein the latchable and releasable latching means are provided in the front region of the cover (6) and of the housing base (4) and prevent the cover (6) from lifting off and moving to the rear, **characterized in that** two latching cams (68, 69) are formed in each case at a distance one behind the other on the outer face of the side walls (60) and, when the cover (54) is pushed onto the housing base (52), engage into associated latching slots (72, 73) which are formed on side webs (70) of the housing base (52), are open to the rear and are inclined substantially obliquely downwards and forwards.

6. Housing according to Claim 5, **characterized in that** the latching means which prevent movement to the rear comprise at least one latching tab (76, 77) which is arranged on a side wall (60) of the cover (54) and, in the mounted state of the cover (54), can be latched to a latching lug which is formed on the housing base (52), and vice versa.

7. Housing according to one of Claims 1 to 6, **characterized in that** the front wall (20) of the cover (6) extends downwards down to a height of a front wall (10) standing on the housing base (4), and **in that** approximately semicircular recesses (12) are formed on the upper edge of the front wall (10) of the housing base (4) and are complemented by approximately semicircular recesses (22) on the lower edge of the front wall (20) of the cover (6) to form substantially circular cable bushing openings.

8. Housing according to Claim 4 or 5 in conjunction with Claim 7, **characterized in that** the latching lug (44) or latching tab (42) which is formed on the housing base (4) is formed or arranged on the front wall (10) of the housing base (4) in each case.

9. Housing according to one of Claims 1 to 8, **characterized in that** channels (80), which each extend along the side walls (60) of the mounted cover (54), for collecting and discharging splashing water running off from the cover are formed on the top side of the housing base (52).

10. Housing according to one of Claims 1 to 9, **characterized in that** a guide lug (46) is arranged on the front wall (20) of the cover (6) and, when the cover (6) is closed, engages into an associated recess (48) which is formed on the front wall (10) of the housing base (4).

## Revendications

1. Boîtier pour un appareil de commande (2), présentant une base de boîtier (4), sur laquelle sont montés des composants de commande pouvant être reliés à des groupes externes au moyen de câbles, un couvercle en forme de hotte (6) avec une paroi de recouvrement supérieure (14), une paroi arrière (16), deux parois latérales (18) et une paroi avant (20), à l'arête inférieure de laquelle sont réalisés des évidements (22) formant des passages de câbles (66), et avec des moyens d'encliquetage disposés d'une part sur la base de boîtier (4) et d'autre part sur le couvercle (6), qui s'engagent l'un dans l'autre lors de la pose du couvercle (6) sur la base de boîtier (4), dans lequel il est prévu dans la région avant du couvercle (6) et de la base de boîtier (4) des moyens d'encliquetage pouvant être encliquetés et libérés, qui bloquent le couvercle (6) contre un soulèvement et un glissement vers l'arrière, **caractérisé en ce qu'**un prolongement de patte (28) orienté en oblique vers le bas et vers l'avant est disposé à l'arête inférieure de la paroi arrière (16) du couvercle (6) sur toute sa largeur, et s'engage de l'arrière vers l'avant dans une rainure associée (30) formée sur la base de boîtier (4), avec une section transversale pointue en forme de coin vers l'avant, lors de la pose du couvercle (6) sur la base de boîtier (4).

2. Boîtier selon la revendication 1, **caractérisé en ce que** le prolongement de patte (38) du couvercle (6) s'épaissit en forme de bourrelet en direction de son arête d'extrémité et la rainure (40) est arrondie en forme de coupelle d'articulation au fond de la rainure.

3. Boîtier selon la revendication 1 ou 2, **caractérisé en ce que** les moyens d'encliquetage bloquant un glissement du couvercle (6) vers l'arrière présentent au moins une saillie orientée vers le bas (34) disposée sur une paroi latérale (18), qui dans l'état monté du couvercle (6) s'engage dans un évidement associé (36) sur la base de boîtier (4).

4. Boîtier selon l'une quelconque des revendications 1 à 3, **caractérisé en ce que** les moyens d'encliquetage bloquant un soulèvement du couvercle (6) présentent au moins une patte d'encliquetage (42) disposée sur la paroi avant (10) du couvercle (6), qui dans l'état monté du couvercle (6) peuvent être encliquetées avec un ergot d'encliquetage (44) formé sur la base de boîtier (4), ou inversement.

5. Boîtier pour un appareil de commande (2), présentant une base de boîtier (4), sur laquelle sont montés des composants de commande pouvant être reliés à des groupes externes au moyen de câbles, un couvercle en forme de hotte (6) avec une paroi de recouvrement supérieure (14), une paroi arrière (16), deux parois latérales (18) et une paroi avant (20), à l'arête inférieure de laquelle sont réalisés des évidements (22) formant des passages de câbles (66), et avec des moyens d'encliquetage disposés d'une part sur la base de boîtier (4) et d'autre part sur le couvercle (6), qui s'engagent l'un dans l'autre lors de la pose du couvercle (6) sur la base de boîtier (4), dans lequel il est prévu dans la région avant du couvercle (6) et de la base de boîtier (4) des moyens d'encliquetage pouvant être encliquetés et libérés, qui bloquent le couvercle (6) contre un soulèvement et un glissement vers l'arrière, **caractérisé en ce que** sur le côté extérieur des parois latérales (60) sont respectivement formées à distance l'une derrière l'autre deux cames d'encliquetage (68, 69), qui s'engagent dans des fentes d'encliquetage (72, 73) associées, formées sur des nervures latérales (70) de la base de boitier (52), ouvertes vers l'arrière et inclinées essentiellement en oblique vers le bas et vers l'avant, lors de la pose du couvercle (54) sur la base de boîtier (52).

6. Boîtier selon la revendication 5, **caractérisé en ce que** les moyens d'encliquetage bloquant un glissement vers l'arrière comprennent au moins une patte d'encliquetage (76, 77) disposée sur une paroi latérale (60) du couvercle (54), qui dans l'état monté du couvercle (54) peut être encliquetée avec un ergot d'encliquetage formé sur la base de boîtier (52), ou inversement.

7. Boîtier selon l'une quelconque des revendications 1 à 6, **caractérisé en ce que** la paroi avant (20) du couvercle (6) s'étend vers le bas jusqu'à hauteur d'une paroi avant (10) dressée sur la base de boîtier (4), et **en ce que** des évidements environ partiellement circulaires (12) sont formés sur l'arête supérieure de la paroi avant (10) de la base de boîtier (4), qui se complètent en des ouvertures de passage de câbles essentiellement circulaires avec des évidements environ partiellement circulaires (22) formés à l'arête inférieure de la paroi avant (20) du couvercle (6).

8. Boîtier selon la revendication 4 ou 5, en liaison avec la revendication 7, **caractérisé en ce que** l'ergot d'encliquetage (44) ou la patte d'encliquetage (42) formé(e) sur la base de boîtier (4) est respectivement formé (e) ou disposé (e) sur la paroi avant (10) de la base de boîtier (4).

9. Boîtier selon l'une quelconque des revendications 1 à 8, **caractérisé en ce que** des rigoles (80) s'étendant respectivement le long des parois latérales (60) du couvercle monté (54) sont formées sur le côté supérieur de la base de boîtier (52) pour recueillir et évacuer des projections d'eau s'écoulant du couvercle.

10. Boîtier selon l'une quelconque des revendications 1 à 9, **caractérisé en ce qu'**un ergot de guidage (46) est disposé sur la paroi avant (20) du couvercle (6), et s'engage dans un évidement associé (48) formé sur la paroi avant (10) de la base de boîtier (4) lors de la fermeture du couvercle (6).
